# EUROPEAN PATENT APPLICATION

(11) **EP 4 760 117 A1**
(43) Date of publication of application: **17.06.2026**
(21) Application number: 24884054.8
(22) Date of filing: 23.07.2024
(51) Int. Cl.: F16C 11/04, H04M 1/02, H05K 5/02

(54) **CONNECTION ASSEMBLY, FOLDING SCREEN, AND FOLDABLE ELECTRONIC DEVICE**

(30) Priority: 30.10.2023 CN 202311431062
(71) Applicant: HUAWEI TECHNOLOGIES CO., LTD., Shenzhen 518129 (CN)
(72) Inventor: LIU, Yong, Shenzhen, Guangdong 518129 (CN); SHI, Tuo, Shenzhen, Guangdong 518129 (CN); LV, Ren, Shenzhen, Guangdong 518129 (CN); ZHONG, Ding, Shenzhen, Guangdong 518129 (CN); YU, Weidong, Shenzhen, Guangdong 518129 (CN); ZHAN, Qiang, Shenzhen, Guangdong 518129 (CN)
(74) Representative: Isarpatent
(86) International application number: PCT/CN2024/107015
(87) International publication number: WO 2025/092046

(57) **Abstract**

A connection component, a foldable display, and a foldable electronic device are provided. The foldable display includes a display (401), middle frames (101, 102), a hinge (201), and a fastener (3). The display (401) is disposed above the middle frames (101, 102) and the hinge (201), the middle frames (101, 102) and the hinge (201) are fastened by using the fastener (3), and the middle frames (101, 102) include a first mechanical part (1) and the hinge (201) includes a second mechanical part (2), or the middle frames (101, 102) include the second mechanical part (2) and the hinge (201) includes the first mechanical part (1). The first mechanical part (1) is provided with a protruding portion (11), a bearing portion (13), and a threaded hole (15), and the threaded hole (15) is at least partially provided on the protruding portion (11). The second mechanical part (2) is provided with a first through hole (21), the second mechanical part (2) is sleeved on a periphery of the protruding portion (11) through the first through hole (21), the second mechanical part (2) includes a first end face (23) and a second end face (25) that are opposite to each other, and the first end face (23) abuts against the bearing portion (13). The fastener (3) includes a base portion (31) and a threaded portion (33), the fastener (3) and the first mechanical part (1) are connected through engagement between the threaded portion (33) and the threaded hole (15), and a third end face (35) of the base portion (31) abuts against the second end face (25). The technical solutions provided in embodiments of this application can improve connection reliability of different components in the foldable display.

## Description

This application claims priority to Chinese Patent Application No. 202311431062.3, filed with the China National Intellectual Property Administration on October 30, 2023 and entitled "CONNECTION COMPONENT, FOLDABLE DISPLAY, AND FOLDABLE ELECTRONIC DEVICE", which is incorporated herein by reference in its entirety.

### TECHNICAL FIELD

This application relates to the field of electronic devices, and more specifically, to a connection component, a foldable display, and a foldable electronic device.

### BACKGROUND

With gradual maturity of flexible organic light-emitting diode (organic light-emitting diode, OLED) technologies, terminal devices with foldable displays (for example, foldable mobile phones) will become a mainstream trend in coming years. A flexible OLED is also referred to as a flexible display.

Screws are commonly used to connect different components in a foldable electronic device. As the foldable electronic device becomes thinner, two components that need to be connected also tend to become thinner.

However, this reduction in a component thickness leads to a shorter length of threads that are engaged with each other, affecting connection reliability of the components.

### SUMMARY

This application provides a connection component, a foldable display, and a foldable electronic device, to improve connection reliability and stability of different components in the foldable display.

According to a first aspect, a foldable display is provided, including a display, a middle frame, a hinge, and a fastener. The display is disposed above the middle frame and the hinge, the middle frame and the hinge are fastened by using the fastener, and the middle frame includes a first mechanical part and the hinge includes a second mechanical part, or the middle frame includes the second mechanical part and the hinge includes the first mechanical part. The first mechanical part is provided with a protruding portion, a bearing portion, and a threaded hole, the protruding portion protrudes from an end face of the bearing portion, and the threaded hole is at least partially provided on the protruding portion. The second mechanical part is provided with a first through hole, the second mechanical part is sleeved on a periphery of the protruding portion through the first through hole, the second mechanical part includes a first end face and a second end face that are opposite to each other, and the first end face abuts against the bearing portion. The fastener includes a base portion and a threaded portion, the threaded portion protrudes from a third end face of the base portion, the fastener and the first mechanical part are connected through engagement between the threaded portion and the threaded hole, and the third end face of the base portion abuts against the second end face of the second mechanical part.

There may be two cases in which the protruding portion protrudes from the end face of the bearing portion: 1. The protruding portion may partially protrude from the end face of the bearing portion. In this case, the threaded hole may be partially or completely provided on the protruding portion. 2. The protruding portion may completely protrude from the end face of the bearing portion. In this case, the threaded hole includes a part provided on the protruding portion and a part provided on the bearing portion, and the two portions of the threaded hole may be through, for being connected to the threaded portion of the fastener.

In this embodiment, the first mechanical part is provided with the protruding portion, and the threaded hole may be at least partially provided on the protruding portion, so that a length of the threaded hole may extend out of the end face of the bearing portion, and the length of the threaded hole of the first mechanical part is increased. In addition, the protruding portion of the first mechanical part is accommodated in the first through hole of the second mechanical part, so that a thickness of the protruding portion can be reduced compared with a solution of directly increasing the thickness of the first mechanical part to increase the length of the threaded hole. The hinge and the middle frame of the foldable display are connected in this manner: The first mechanical part is disposed on the hinge and the second mechanical part is disposed on the middle frame, or the second mechanical part is disposed on the hinge and the first mechanical part is disposed on the middle frame, so that the hinge and the middle frame can be reliably connected.

With reference to the first aspect, in some implementations of the first aspect, a difference between a diameter d2 of the first through hole and an outer diameter d3 of the protruding portion is greater than a first threshold.

The difference between the diameter of the first through hole and the outer diameter of the protruding portion is greater than the first threshold, so that an adjustment allowance of a relative position between the first mechanical part and the second mechanical part is greater than the first threshold, to facilitate alignment between the first mechanical part and the second mechanical part.

With reference to the first aspect, in some implementations of the first aspect, an end that is of the second mechanical part and that is close to the base portion 31 includes a countersunk hole, the second end face is an end face between the first through hole and the countersunk hole, and the second mechanical part is sleeved on a periphery of the base portion through the countersunk hole.

The countersunk hole being sleeved on the periphery of the base portion means that the base portion is partially or completely accommodated in the countersunk hole. When a threaded connection length remains unchanged, a thickness of the second mechanical part may be properly increased, to improve strength and reliability of a component disposed with the second mechanical part in the foldable display.

With reference to the first aspect, in some implementations of the first aspect, an opening that is of the threaded hole and that is close to the base portion is provided with a chamfer.

The opening of the threaded hole is provided with the chamfer to facilitate self-tapping of the threaded hole. In other words, the threaded hole of the first mechanical part may be pre-machined, or may be formed through self-tapping when the first mechanical part and the second mechanical part are mounted by using the fastener.

With reference to the first aspect, in some implementations of the first aspect, a thread length of the threaded hole is more than three times a pitch of the threaded hole.

In this way, threads in the threaded hole are denser, and when the threaded portion is engaged with the threaded hole, a threaded contact area between the fastener and the first mechanical part is also increased, so that a fastener-based connection between the first mechanical part and the second mechanical part becomes more reliable.

Optionally, a thread length of the threaded hole may alternatively be greater than twice or more than twice a pitch of the threaded hole.

With reference to the first aspect, in some implementations of the first aspect, the protruding portion is a nut, and the bearing portion further includes a second through hole. The nut includes a head and a shank, the shank protrudes from an end face of the head, and the threaded hole is provided in the nut. The nut is secured in the second through hole, the shank extends out of the end face of the bearing portion, and the shank is accommodated in the first through hole.

With reference to the first aspect, in some implementations of the first aspect, the threaded portion of the fastener faces away from the display.

With reference to the first aspect, in some implementations of the first aspect, the threaded portion of the fastener faces the display.

If the threaded portion of the fastener faces the display, the base portion of the fastener is on a cover plate side of the foldable display. In this way, the fastener can be conveniently removed from the cover plate side by using the base portion, to facilitate operations such as removal and maintenance of the foldable display.

With reference to the first aspect, in some implementations of the first aspect, an end part of the threaded portion of the fastener does not protrude from an end face that is of the first mechanical part and that is away from the second mechanical part.

Because the end part of the threaded portion of the fastener does not protrude from the end face that is of the first mechanical part and that is away from the second mechanical part, the sharp threaded portion does not damage another component close to the first mechanical part.

According to a second aspect, a connection component is provided for use in a foldable electronic device. The connection component includes a first mechanical part, a second mechanical part, and a fastener. The first mechanical part is provided with a protruding portion, a bearing portion, and a threaded hole, the protruding portion protrudes from an end face of the bearing portion, and the threaded hole is at least partially provided on the protruding portion. The second mechanical part is provided with a first through hole, the second mechanical part is sleeved on a periphery of the protruding portion through the first through hole, the second mechanical part includes a first end face and a second end face that are opposite to each other, and the first end face abuts against the bearing portion. The fastener includes a base portion and a threaded portion, the threaded portion protrudes from a third end face of the base portion, the fastener and the first mechanical part are connected through engagement between the threaded portion and the threaded hole, and the third end face of the base portion abuts against the second end face of the second mechanical part.

With reference to the second aspect, in some implementations of the second aspect, a difference between a diameter d2 of the first through hole and an outer diameter d3 of the protruding portion is greater than a first threshold.

With reference to the second aspect, in some implementations of the second aspect, an end that is of the second mechanical part and that is close to the base portion includes a countersunk hole, the second end face is an end face between the first through hole and the countersunk hole, and the second mechanical part is sleeved on a periphery of the base portion through the countersunk hole.

With reference to the second aspect, in some implementations of the second aspect, an opening that is of the threaded hole and that is close to the base portion is provided with a chamfer.

With reference to the second aspect, in some implementations of the second aspect, a thread length of the threaded hole is more than three times a pitch of the threaded hole.

With reference to the second aspect, in some implementations of the second aspect, the protruding portion is a nut, and the bearing portion further includes a second through hole. The nut includes a head and a shank, the shank protrudes from an end face of the head, and the threaded hole is provided in the nut. The nut is secured in the second through hole, the shank extends out of the end face of the bearing portion, and the shank is accommodated in the first through hole.

With reference to the second aspect, in some implementations of the second aspect, an end part of the threaded portion of the fastener does not protrude from an end face that is of the first mechanical part and that is away from the second mechanical part.

According to a third aspect, a foldable electronic device is provided, including the foldable display according to the first aspect or any one of the implementations of the first aspect.

### BRIEF DESCRIPTION OF DRAWINGS

FIG. 1 is a top view of a foldable electronic device according to this application;
FIG. 2 is a side view of a foldable electronic device according to this application;
FIG. 3 is a partial enlarged view of the foldable electronic device corresponding to FIG. 2;
FIG. 4 is another partial enlarged view of the foldable electronic device corresponding to FIG. 2;
FIG. 5 is a diagram of an alignment problem that may arise with the foldable electronic device shown in FIG. 4;
FIG. 6 is a diagram of a connection component according to an embodiment of this application;
FIG. 7 is a diagram of another connection component according to an embodiment of this application;
FIG. 8 is a diagram of still another connection component according to an embodiment of this application;
FIG. 9A and FIG. 9B are diagrams of yet another connection component according to an embodiment of this application;
FIG. 10 is a diagram of a foldable display according to an embodiment of this application;
FIG. 11 is a top view of the foldable display corresponding to FIG. 10;
FIG. 12 is a diagram of another foldable display according to an embodiment of this application;
FIG. 13 is a diagram of still another foldable display according to an embodiment of this application;
FIG. 14 is a top view of the foldable display corresponding to FIG. 13; and
FIG. 15 is a diagram of yet another foldable display according to an embodiment of this application.

### DESCRIPTION OF EMBODIMENTS

The following describes the technical solutions of this application with reference to the accompanying drawings.

The following describes embodiments of this application in detail. Examples of embodiments of this application are shown in the accompanying drawings. In the accompanying drawings, same or similar reference numerals indicate same or similar elements or elements having same or similar functions. The following embodiments described with reference to the accompanying drawings are examples, and are merely intended to explain this application, but should not be construed as a limitation on this application.

In descriptions of this application, it should be understood that the terms "first", "second", and "third" are merely used for description, and cannot be understood as an indication or implication of relative importance, or an implicit indication of a quantity of indicated technical features. Therefore, a feature limited by "first", "second", or "third" may explicitly or implicitly include one or more features. In descriptions of this application, "a plurality of" means two or more than two, unless otherwise specifically limited.

In descriptions of this application, it should be noted that, unless otherwise specified and limited, the terms "mounting" and "connection" should be understood in a broad sense. For example, a connection may be fastening, a detachable connection, or an integrated connection. Alternatively, a connection may be a mechanical connection, an electrical connection, or mutual communication. Alternatively, a connection may be a direct connection, an indirect connection through an intermediate medium, or a connection between two elements or an interaction relationship between two elements. A person of ordinary skill in the art may understand specific meanings of the foregoing terms in this application based on specific situations.

Unless otherwise defined, a technical term or a scientific term used herein shall have a general meaning understood by a person of ordinary skill in the technical field of this application. In descriptions of this application, it should be understood that orientation or position relationships indicated by the terms such as "center", "longitudinal", "transverse", "above", "below", "front", "back", "left", "right", "vertical", "horizontal", "top", "bottom", "inside", and "outside" are based on orientation or position relationships shown in the accompanying drawings, and are merely used for ease and brevity of description of this application, rather than indicating or implying that the indicated apparatus or element needs to have a particular orientation or needs to be constructed and operated in a particular orientation. Therefore, such terms should not be construed as a limitation on this application.

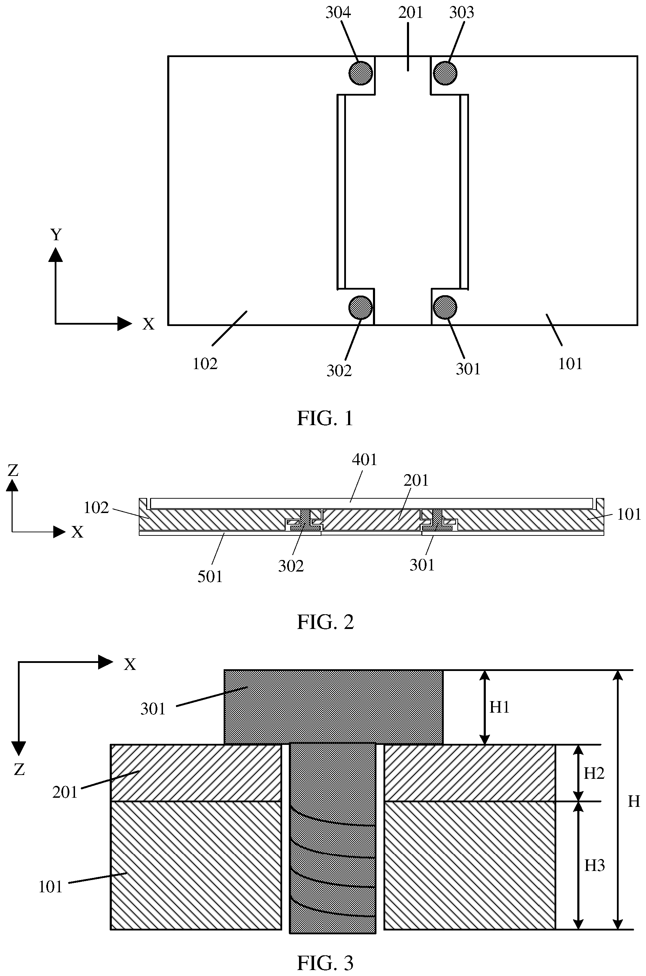

FIG. 1 and FIG. 2 are diagrams of a foldable display of a foldable electronic device. FIG. 1 is a top view (X-Y plane), and FIG. 2 is a side sectional view (X-Z plane). The foldable display includes a middle frame 101, a middle frame 102, a hinge 201, a screw 301, a screw 302, a screw 303, a screw 304, a display 401, and a rear cover 501.

A quantity of screws is shown as an example. The quantity of screws in the foldable display may be greater than or less than 4. A specific quantity may be set as required. This is not limited in this application.

The right side of the middle frame 101 and the left side of the middle frame 102 each have a threaded hole for threaded connection, and the hinge 201 may be provided with a through hole. The screw 301, the screw 302, the screw 303, and the screw 304 symmetrically fasten the middle frame 101 and the middle frame 102 to two sides of the hinge 201. The display 401 covers the middle frame 101, the middle frame 102, and the hinge 201. The display 401 includes a flexible cover and a display panel, and has a bendable characteristic. The display 401 may be used to display information and provide an interaction interface for users. The rear cover 501 may include parts corresponding to the middle frame 101 and the middle frame 102, and may further include a part corresponding to the hinge 201, for protecting an internal structure of the foldable display.

The foldable electronic device may implement a display function through a graphics processing unit (Graphics Processing Unit, GPU), the display 401, an application processor, and the like. The GPU is a microprocessor for image processing, and is connected to the display 401 and the application processor. The GPU is configured to: perform mathematical and geometric computation, and render an image. A processor of the foldable electronic device may include one or more GPUs that execute program instructions to generate or change display information. The display 401 is configured to display an image, a video, and the like. The display 401 includes the display panel. The display panel may be a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flexible light-emitting diode, FLED), a mini-LED, a micro-LED, a micro-OLED, a quantum dot light-emitting diode (quantum dot light-emitting diode, QLED), or the like. The foldable electronic device may implement a photographing function through an ISP, a camera, a video codec, the GPU, the display 401, the application processor, and the like. In some embodiments, the foldable electronic device may include one or N displays 401, where N is a positive integer greater than 1.

FIG. 3 is a partial enlarged view of a connection part between the hinge 201 and the middle frame 101 of the foldable display shown in FIG. 2. The partial enlarged view includes the screw 301, a part of the hinge 201, and a part of the middle frame 101. For example, the part of the hinge 201 may be a mounting plate of the hinge 201, and the part of the middle frame 101 may also be a mounting plate of the middle frame 101. Unless otherwise specified, the hinge 201 refers to the part of the hinge, and the middle frame 101 also refers to the part of the middle frame. For example, a thickness of the hinge 201 is a thickness of the part of the hinge 201, and a thickness of the middle frame 101 is a thickness of the part of the middle frame 101, and the thickness of the hinge and the thickness of the middle frame do not mean a total thickness or a maximum thickness of the entire hinge 201 and the entire middle frame 101. The screw 301 is a pan head screw. A lower end face (an end face close to a shank) of a pan head part of the screw 301 abuts against the hinge 201, causing a lower end face of the hinge 201 to press against the middle frame 101. Prior to mounting the screw 301, because a diameter of the through hole of the hinge 201 is greater than an outer diameter of the shank of the screw 301, there is a specific adjustment allowance between the hinge 201 and the middle frame 101. The adjustment allowance allows for alignment between the hinge 201 and the middle frame 101 and then fastening them together with a pan head screw. During mounting of the screw 301, the pan head part of the screw 301 is in surface contact with the hinge 201, the screw 301 applies pressure in a Z direction to the hinge 201, and the hinge 201 does not bear a force on the XY plane. Therefore, a relative position between the aligned hinge 201 and middle frame 101 on the XY plane is not misplaced again due to mounting of the screw. Therefore, using the pan head screw cannot affect alignment between the hinge 201 and the middle frame 101.

A thickness H of the structure shown in FIG. 3 includes a thickness H1 of a pan head of the screw 301, a thickness H2 of the hinge 201, and a thickness H3 of the middle frame 101. However, a part of the shank of the screw is fastened through a threaded hole of the middle frame 101 and the through hole of the hinge 201. Therefore, an effective thread length of the screw 301 is only a length of a contact surface between the screw 301 and the threaded hole of the middle frame 101, that is, a maximum effective thread length=H-H1-H2. An effective thread is a part of a thread that is on the shank of the screw 301 and that is engaged with the threaded hole of the middle frame 101. When the foldable electronic device is extremely thin, because a head of the screw 301 has a specific thickness, the effective thread length may be insufficient, compromising reliability and stability of a structural connection of the foldable electronic device.

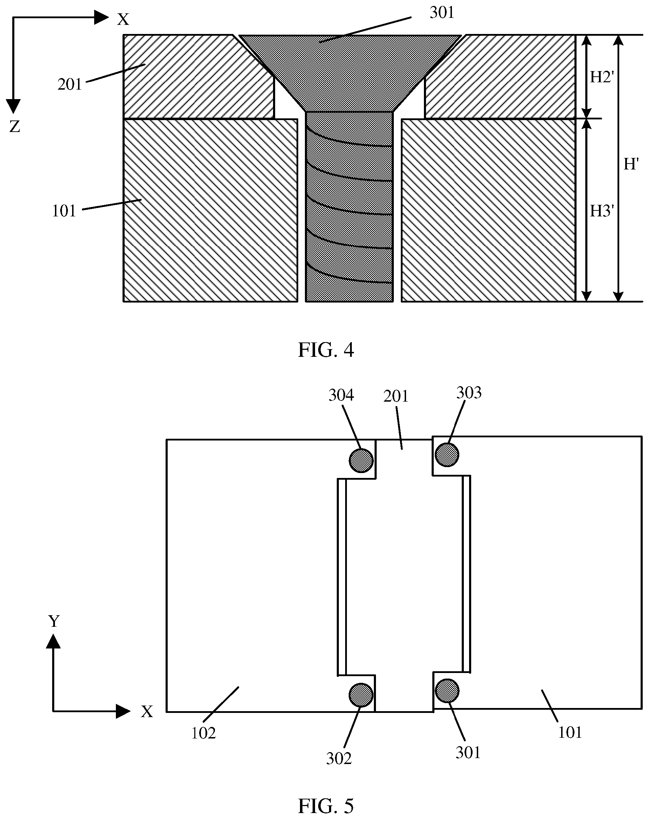

FIG. 4 is another partial enlarged view of a connection part between the hinge 201 and the middle frame 101 of the foldable display shown in FIG. 2. The foldable electronic device includes the screw 301, the hinge 201, and the middle frame 101. The screw 301 is a countersunk screw. Because a head of the screw 301 may be recessed into the through hole of the hinge 201, a thickness of the connection part may be reduced with a thickness of the head of the screw 301, so that the thickness of the middle frame 101 and a length of the threaded hole provided in the middle frame 101 may increase, thereby improving connection reliability between the hinge 201 and the middle frame 101.

Specifically, a thickness H' of the structure shown in FIG. 4 includes a thickness H2' of the hinge 201 and a thickness H3' of the middle frame 101. Because a part of the shank of the screw 301 is fastened through a threaded hole of the middle frame 101, an effective thread length of the screw 301 is a length of a contact surface between the screw 301 and the middle frame 101, that is, a maximum effective thread length=H'-thickness H2' of the mounting plate of the hinge 201=H3'. The connection part differs from the connection part in FIG. 3 in that a countersunk head may be recessed into the hinge 201. In an aspect, if the total thickness H' of the connection structure is the same as the total thickness H in FIG. 3 and the thickness of the hinge 201 remains unchanged (H2'=H2), the thickness of the middle frame 101 may increase, and a maximum increase is a thickness of the countersunk head (that is, H3'=H3+H1). Therefore, the length of the threaded hole in the middle frame 101 may also increase, thereby prolonging the effective thread length of the screw 301, and improving reliability and stability of a structural connection of the foldable electronic device. In another aspect, if the total thickness remains unchanged (H'=H) and connection strength is not reduced (that is, the effective thread length H3' is the same as H3 in FIG. 3), the thickness of the hinge 201 may increase, thereby improving reliability of the hinge.

However, to accommodate the countersunk head of the screw 301, an upper end face of the through hole of the hinge 201 usually needs to be provided with a chamfer, so that the countersunk head of the screw 301 is in limited contact with a bevel of the chamfer of the hinge 201, where the countersunk head of the screw 301 is in line contact or conical contact with the bevel of the chamfer of the hinge 201. In this way, in addition to a force in the Z direction that causes the hinge 201 and the middle frame 101 to press against each other, the screw 301 applies a force on the XY plane force to the hinge 201 through the head. The downward pressure in the Z direction applied by the screw 301 to the hinge 201 causes the hinge 201 to press downward against the middle frame 101, but the force on the XY plane causes relative displacements of the hinge 201 and the middle frame 101 on the XY plane. In this way, even if the hinge 101 and the middle frame 201 are already aligned before the two are fastened, a relative position between the two may be displaced by a force on the XY plane when the two are fastened. With reference to FIG. 5, when the middle frame 101, the middle frame 102, and the hinge 201 are fastened, a structural displacement shown in the figure may be generated.

However, in the structures in FIG. 3 and FIG. 4, connection reliability is reduced because the effective thread length is short, or the effective thread length is increased by sacrificing adjustability of the two components, to improve connection reliability. Therefore, this application provides a connection component, to improve connection reliability without sacrificing adjustability between components.

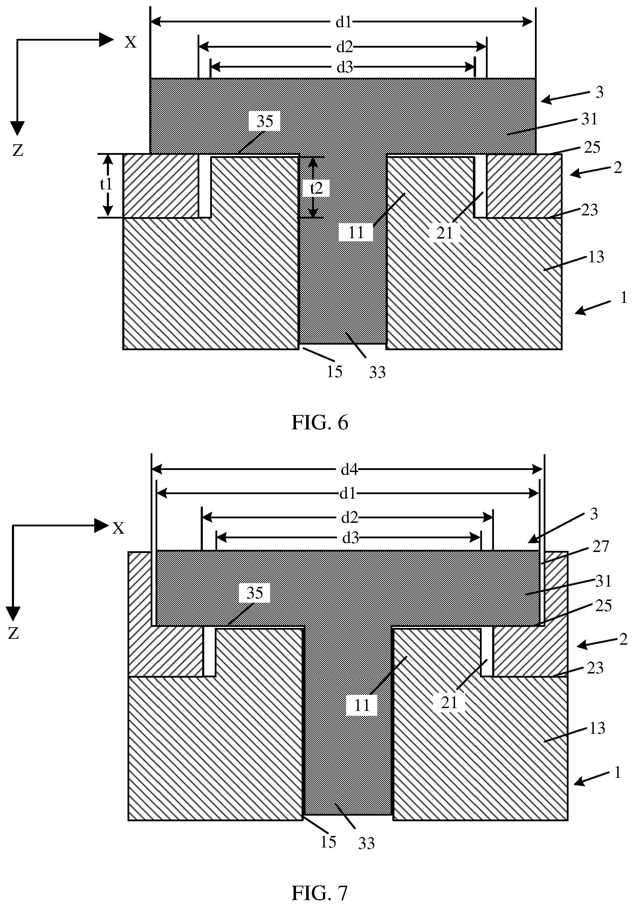

FIG. 6 is a sectional view of a connection component according to an embodiment of this application. The connection component includes a first mechanical part 1, a second mechanical part 2, and a fastener 3.

The first mechanical part 1 is provided with a protruding portion 11, a bearing portion 13, and a threaded hole 15. The protruding portion 11 protrudes from an end face of the bearing portion. The threaded hole 15 is at least partially provided on the protruding portion 11. The second mechanical part 2 is provided with a first through hole 21. The second mechanical part 2 is sleeved on a periphery of the protruding portion 11 through the first through hole 21. The second mechanical part 2 includes a first end face 23 and a second end face 25 that are opposite to each other. The first end face 23 abuts against the bearing portion 13 of the first mechanical part 1. The fastener 3 includes a base portion 31 and a threaded portion 33. The threaded portion 33 protrudes from a third end face 35 of the base portion 31. The fastener 3 and the first mechanical part 1 are connected through engagement between the threaded portion 33 and the threaded hole 15. The third end face 35 of the base portion 31 of the fastener 3 abuts against the second end face 25 of the second mechanical part 2. The first end face 23 of the second mechanical part 2 abuts against the bearing portion 13 of the first mechanical part 1, so that the fastener 3, the first mechanical part 1, and the second mechanical part 2 can be connected to each other through a plurality of abutted surfaces and engaged threaded surfaces.

The protruding portion 11 of the first mechanical part 1 increases a size of the first mechanical part 1 in a vertical direction, thereby increasing a length of the threaded hole 15, increasing a length of a threaded connection between the first mechanical part 1 (the threaded hole 15) and the fastener 3 (the threaded portion 33), and improving connection reliability between the first mechanical part 1, the second mechanical part 2, and the fastener 3. In addition, because the second mechanical part 2 is sleeved on the periphery of the protruding portion 11 of the first mechanical part 1 through the first through hole 21, there is a specific adjustment allowance between the second mechanical part 2 and the first mechanical part 1, to facilitate alignment between the second mechanical part 2 and the first mechanical part 1.

In this embodiment, the first mechanical part 1 is step-shaped, and includes an upper step surface and a lower step surface. The upper step surface is a surface that is of the first mechanical part 1 and that is close to the third end face 35 of the fastener 3, and the lower step surface is a surface that is of the first mechanical part 1 and that abuts against the first end face 23 of the second mechanical part 2. In this case, the protruding portion 11 represents a part that is of the first mechanical part 1 and that protrudes from the lower step surface, namely, a part between the upper step surface and the lower step surface. The bearing portion 13 may be a part between a bottom surface and the lower step surface of the first mechanical part 1. The protruding portion 11 and the bearing portion 13 of the first mechanical part 1 are integrated. The protruding portion 11 is disposed above the bearing portion 13 and the protruding portion 11 is a boss post, which may also be referred to as a screw post. The threaded hole 15 of the first mechanical part 1 is a threaded hole that extends through the protruding portion 11 and the bearing portion 13, and two parts of the threaded hole have equal diameters.

A thickness t1 of a part that is of the second mechanical part 2 and that abuts with the first mechanical part 1 and the fastener 3 is greater than a thickness t2 of the protruding portion 11 of the first mechanical part 1, and a diameter d1 of the base portion 31 of the fastener 3 is greater than a diameter d2 of the first through hole 21 of the second mechanical part 2, so that the third end face 35 of the base portion 31 of the fastener 3 is in limited contact with the second end face 25 of the second mechanical part 2. That is, the third end face 35 of the base portion 31 of the fastener 3 presses against the second end face 25 of the second mechanical part 2 to fasten the second mechanical part 2, and prevent the fastener 3 from being in limited contact with an upper end face of the protruding portion 11 of the first mechanical part 1, so that the second mechanical part 2 can be fastened. An outer diameter d3 of the protruding portion 11 of the first mechanical part 1 is less than the diameter d2 of the first through hole 21 of the second mechanical part 2, so that during fastening of the connection component, the second mechanical part 2 is only subjected to a force applied by the fastener 3 in the Z direction. This allows for a specific adjustment degree of a relative position between the first mechanical part 1 and the second mechanical part 2 has on the XY plane. Before the second mechanical part 2 is fastened to the first mechanical part 1, the relative position between the first mechanical part 1 and the second mechanical part 2 may be adjusted, so that the first mechanical part 1 is first aligned with the second mechanical part 2.

The threaded portion 33 of the fastener 3 is in threaded engagement with the threaded hole 15 of the first mechanical part 1. A surface on which the threaded portion 33 of the fastener 3 is engaged with the threaded hole 15 of the first mechanical part 1 is a first contact surface, and a maximum length of the first contact surface may be a length of the threaded hole 15 of the first mechanical part 1. Because the protruding portion 11 of the first mechanical part 1 increases a thickness of the first mechanical part, the length of the threaded hole 15 may also be increased, that is, a length of the first contact surface may be increased. Therefore, when a thickness of the connection component remains unchanged, the first mechanical part 1 is in threaded engagement with the fastener 3, thereby improving connection reliability and stability of the component.

It should be understood that the threaded hole 15 in FIG. 6 extends through the first mechanical part 1. Actually, the threaded hole 15 may alternatively be a blind hole, and an end face, away from the second mechanical part, of the first mechanical part 1 may be closed.

In an embodiment, a difference between the diameter d2 of the first through hole 21 of the second mechanical part 2 and the outer diameter d3 of the protruding portion of the first mechanical part 1 may be greater than a first threshold, so that a central axis of the second mechanical part 2 can move toward or away from a central axis of the threaded hole by a distance up to this first threshold.

In an embodiment, a sum of a thickness of the bearing portion 13 of the first mechanical part 1, a thickness of the second mechanical part 2, and a thickness of the base portion 31 of the fastener 3 may not exceed a preset threshold. This can reduce a thickness of the connection component as possible. For example, when the connection component is used in a foldable electronic device, a thickness of the foldable electronic device can also be reduced as possible.

In some examples, after the fastener 3 is fastened to the first mechanical part 1, the threaded portion 33 of the fastener 3 may not exceed a lower end face of the first mechanical part 1 (the lower end face of the first mechanical part 1 is an end face that is of the first mechanical part 1 and that is away from the base portion 31 of the fastener 3), to prevent the sharp threaded portion 33 from interfering with or damaging another structural component. For example, the threaded hole 15 is a blind hole, or the threaded hole 15 is a through hole. However, a length of the threaded portion 33 of the fastener 3 is such that when the threaded portion 33 is engaged with the threaded hole 15, a bottom of the threaded portion 33 does not protrude from an end face of a bottom of the first mechanical part 1.

In some examples, a thread length of the threaded hole 15 is greater than n times a pitch of the threaded hole 15, where n is a positive number. For example, n may be greater than or equal to 3. For example, n may be 3, 4, 5... In this way, threads on the threaded hole 15 are more densely distributed, increasing a contact area between the threaded hole 15 and the threaded portion 33 per unit length, thereby improving connection reliability between the fastener 3 and the first mechanical part 1. Certainly, n may alternatively be another positive number such as 2, 2.5, or the like. This is not limited in this application.

In some examples, as shown in FIG. 7, an end that is of the second mechanical part 2 and that is close to the base portion 31 further includes a countersunk hole 27. A diameter of the countersunk hole 27 is greater than the diameter of the base portion 31. The second mechanical part 2 is sleeved on a periphery of the base portion of the fastener 3 through the countersunk hole 27. Because of the countersunk hole 27, a part or an entirety of the base portion 31 of the fastener 3 may be disposed in the countersunk hole 27. When the length of the threaded connection between the fastener 3 and the first mechanical part 1 and a maximum thickness of the entire connection component remain unchanged, the thickness of the second mechanical part 2 may be increased by a maximum of the thickness of the base portion 31 of the fastener 3, thereby improving reliability of the second mechanical part 2.

It should be understood that the base portion 31 of the fastener 3 in FIG. 7 is completely accommodated in the countersunk hole 27. In some embodiments, a depth of the countersunk hole 27 may be set to enable the base portion 31 to be partially accommodated.

A diameter d4 of the countersunk hole is greater than the diameter d1 of the base portion 31. When the relative position between the first mechanical part 1 and the second mechanical part 2 is adjusted by using the connection component shown in FIG. 7, the fastener 3 and the first mechanical part 1 move together relative to the second mechanical part 2.

In a case, an adjustment allowance between the first mechanical part 1 and the second mechanical part 2 depends on a difference between the diameter d4 of the countersunk hole 27 and the diameter d1 of the base portion 31. During adjustment, contact between a side surface of the base portion 31 of the fastener 3 and a hole wall of the countersunk hole 27 limits further relative motion between the first mechanical part 1 and the second mechanical part 2.

In another case, an adjustment allowance between the first mechanical part 1 and the second mechanical part 2 depends on a difference between the diameter d2 of the first through hole 21 and the outer diameter d3 of the protruding portion 11. During adjustment, contact between the protruding portion 11 and a hole wall of the first through hole 21 limits further relative motion between the first mechanical part 1 and the second mechanical part 2.

In other words, an adjustment allowance between the first mechanical part 1 and the second mechanical part 2 is c≤(d4-d1) and c≤(d2-d3).

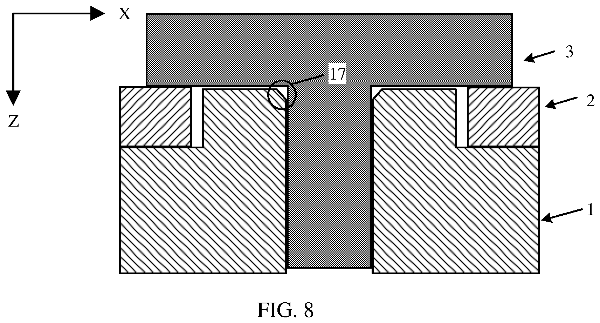

In some examples, as shown in FIG. 8, an opening that is the threaded hole 15 of the first mechanical part 1 and that is close to the base portion 31 is provided with a chamfer 17, to help obtain a thread of the threaded hole 15 through self-tapping. An inner diameter of an upper end face of the threaded hole 15 of the first mechanical part 1 is provided with the chamfer 17, so that the fastener 3 is fastened along the threaded hole of the first mechanical part 1. In other words, the threaded hole 15 may be pre-processed on the first mechanical part 1, or may be self-tapped when the fastener 3 is connected to the first mechanical part 1.

It should be understood that the countersunk hole 27 and the chamfer 17 may be both provided, so that the first mechanical part 1 and the second mechanical part 2 in the connection component can be connected more conveniently, and a thickness of the second mechanical part 2 in the connection component may be increased properly. For details, refer to the foregoing descriptions. Details are not described herein again.

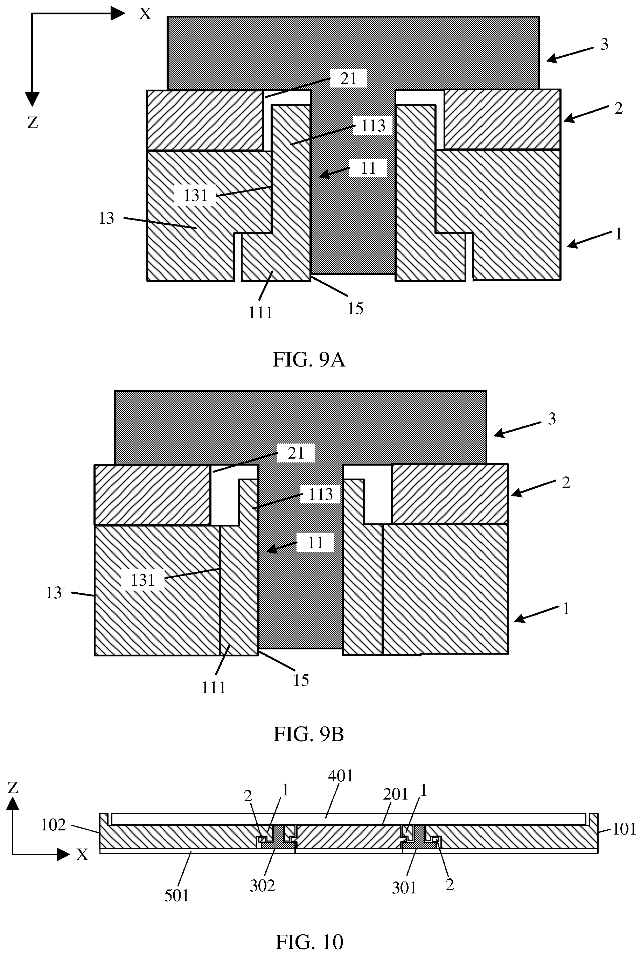

As shown in FIG. 9A, in another embodiment, a structure of the connection component 1 may be different from that in the foregoing embodiment. The connection component may still include the first mechanical part 1, the first mechanical part 2, and the fastener 3. The first mechanical part 1 further includes a nut, and the nut is equivalent to the protruding portion 11 described above. In other words, the protruding portion 11 and the bearing portion 13 are separated from each other.

The bearing portion 13 further includes a second through hole 131. The nut further includes a head 111 and a shank 113. The shank 111 protrudes from an end face of the head 113, and a threaded hole is provided in the nut. The nut is secured in the second through hole 131, and the shank 113 of the nut extends out of an end face of the bearing portion 13, so that the first through hole 21 of the second mechanical part 2 may be sleeved on an outer side of an end that is of the shank of the nut and that is away from the head 111.

The nut 11 may be combined with the bearing portion 13 from the bottom of the first mechanical part 1 through riveting or pressurization, to form the first mechanical part 1.

It should be understood that the head 111 and the shank 113 of the nut in FIG. 9A are both secured in the second through hole 131, and the second through hole 131 includes a part for accommodating the head 111 and a part for accommodating the shank 113 (the second through hole 131 is a step hole). In this way, the head 111 of the nut does not exceed a bottom end face of the bearing portion 13, so that impact on other components connected to the connection component can be reduced. However, in some embodiments, alternatively, the head 111 of the nut may not be accommodated or not be fully accommodated in the second through hole 131. In this way, an upper end face of the head 111 of the nut (an end face that is of the head 111 of the nut and that is close to the shank 113) may press against a bottom end face of the bearing portion 13 (namely, an end face that is of the bearing portion 13 and that is away from the second mechanical part 2).

In addition, the nut in FIG. 9A is secured through contact between a side wall of the shank 113 and a side wall of the second through hole 131 of the bearing portion 13. In some embodiments, the nut may alternatively be secured through contact between a side wall of the head 111 and a side wall of the second through hole 131 of the bearing portion 13. As shown in FIG. 9B, the side wall of the second through hole 131 abuts against the side surface of the head 111 of the nut, thereby securing the nut in the bearing portion 13.

In FIG. 9B, a thickness of the head 111 of the nut is the same as a thickness of the bearing portion 13 of the first mechanical part 1. In some embodiments, an end face between the head 111 and the shank 113 of the nut may not exceed an upper end face of the bearing portion 13, that is, a part of the shank 113 of the nut is sleeved in the second through hole 131.

For the connection component shown in FIG. 9A and FIG. 9B, a diameter of the shank 113 of the nut is less than the diameter of the first through hole 21 of the second mechanical part 2, and the diameter of the base portion 31 of the fastener 3 is greater than the diameter of the first through hole 21, so that a specific adjustment allowance exists between the first mechanical part 1 and the second mechanical part 2, and the fastener 3 presses against the second end face of the second mechanical part 2.

In some embodiments, a difference between the diameter of the first through hole 21 and the diameter of the shank 113 of the nut may be greater than the first threshold.

In an embodiment, a sum of the thickness of the bearing portion 13 of the first mechanical part 1, the thickness of the second mechanical part 2, and the thickness of the base portion 31 of the fastener 3 may not exceed a preset threshold, so that a thickness of a foldable electronic device in which the connection component is used may be reduced as possible.

In an embodiment, the head 111 of the nut may not exceed the end face of the bearing portion 13, thereby reducing impact of the nut on a component adjacent to the connection component.

In an embodiment, an internal thread length of the nut is greater than n times a pitch, for example, n may be 3 or another value.

Certainly, a countersunk hole and/or a chamfer may alternatively be provided in the connection structure shown in FIG. 9A and FIG. 9B. Specifically, the countersunk hole may be provided on the second mechanical part 2, and the chamfer may be provided at an opening that is of the threaded hole 15 and that is close to the base portion 31. For specific details, refer to the foregoing descriptions. Details are not described herein again.

This application further provides a foldable display. FIG. 10 is a diagram of an X-Z cross section of the foldable display.

The foldable display includes a display 401, a middle frame 101, a middle frame 102, a hinge 201, a rear cover 501, and a plurality of screws. The plurality of screws may include, for example, a screw 301, a screw 302, a screw 303, and a screw 304. The screw is equivalent to the fastener 3 described above. The display 401 is disposed above the middle frame 101, the middle frame 102, and the hinge 201. The middle frame 101, the middle frame 102, and the hinge 201 are fastened by using the fastener 3. The middle frame 101 and the middle frame 102 include a first mechanical part 1, and the hinge 201 includes a second mechanical part 2 connected to the middle frame 101 and the middle frame 102. The display 401 is disposed on a side that is of the fastener 3 and that is close to a threaded portion 33. The rear cover 501 is disposed on a side that is of the fastener and that is close to a base portion 31.

In some embodiments, a countersunk hole may be provided on the second mechanical part 2 of the hinge 201, so that a head of the screw may be partially disposed in the countersunk hole. When a length of a connection thread and a total thickness of a connection part remain unchanged, a thickness of the hinge 201 at at least the second mechanical part 2 may be properly increased.

An opening of a threaded hole 15 of the first mechanical part 1 of the middle frame 101 and the middle frame 102 may be further provided with a chamfer, to help connect the hinge 201 to the middle frame 101 and the middle frame 102.

The first mechanical part 1 of the middle frame 101 and the middle frame 102 may further include a nut, and the nut may be disposed in a through hole of a bearing portion 13 of the first mechanical part 1 through riveting or pressurization.

For specific structures of the first mechanical part 1, the second mechanical part 2, and the fastener 3, refer to the foregoing descriptions of FIG. 6 to FIG. 9B. Details are not described herein again.

Because the base portion 31 of the fastener 3 (namely, the head of the screw) is disposed on a side of the rear cover 501 (that is, the threaded portion 33 of the fastener 3 extends toward a side of the display), when the foldable display needs to be repaired, the rear cover may be directly opened to expose the head of the screw, so that the display can be disassembled and repaired from the head.

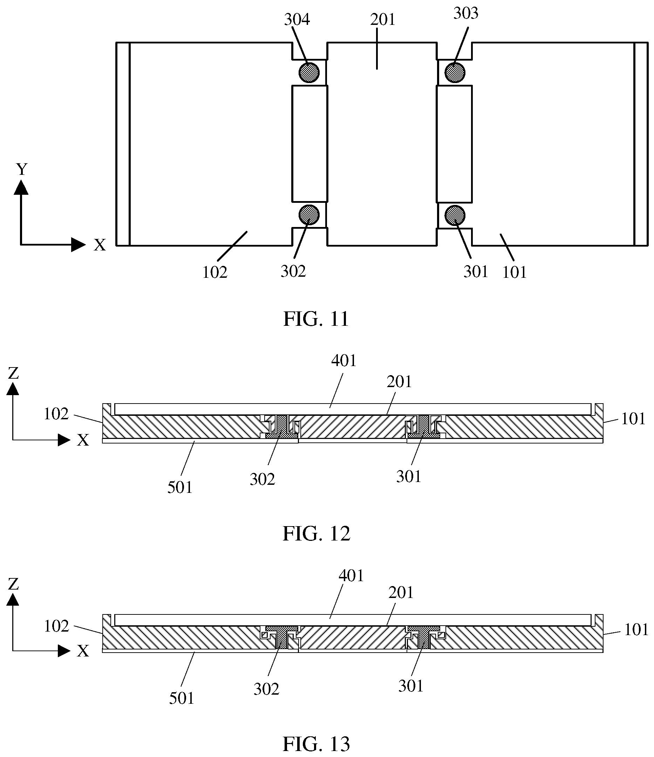

FIG. 11 is a top view of a display side of the foldable display corresponding to FIG. 10. It can be seen from FIG. 11 that two groups of connection components may be configured to connect the hinge 201 to the middle frame 101 and the middle frame 102 respectively. These connection components include the screw 301, the screw 302, the screw 303, and the screw 304. In addition, on the display side, it can be seen that threaded portions of the screw 301 to the screw 304 are close to the side, and heads of the screws are close to the rear cover, to facilitate operations such as disassembly of the foldable display after the rear cover is opened.

This application provides another embodiment of a foldable display, as shown in FIG. 12. The foldable display differs from the foldable display shown in FIG. 10 in that the first mechanical part 1 is disposed on the hinge 201, and the second mechanical part 2 is disposed on the middle frame 101 and the middle frame 102. For example, a material of the first mechanical part 1 of the hinge 201 may be an iron-based metal material, and a material of the second mechanical part 2 of the middle frame 101 and the middle frame 102 may be a light-weight material like an aluminum-based metal material or a magnesium-based metal material. The countersunk hole is provided so that thicknesses of the middle frame 101 and the middle frame 102 can be properly increased, thereby improving strength of the middle frame 101 and the middle frame 102. For specific details of the first mechanical part 1, the second mechanical part 2, and the fastener 3, refer to descriptions in FIG. 6 to FIG. 10. Details are not described herein again. For a top view of a display side corresponding to the foldable display shown in FIG. 12, refer to FIG. 11.

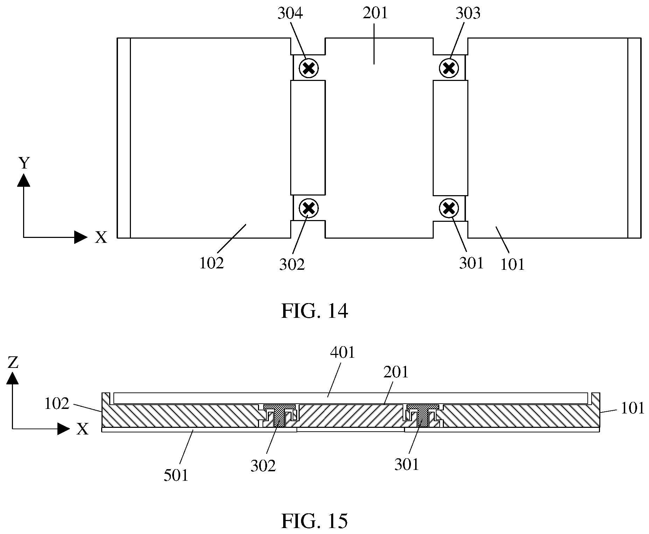

This application provides still another embodiment of a foldable display, as shown in FIG. 13. Similar to the foldable display shown in FIG. 10, in the foldable display in FIG. 13, the first mechanical part 1 including a threaded hole is disposed on the middle frame 101 and the middle frame 102, and the second mechanical part 2 is disposed on the hinge 201. However, in the foldable display shown in FIG. 13, a base portion of a fastener (a head of a screw) is close to the display, that is, a threaded portion of the fastener extends back to a display side. FIG. 14 is a top view of the foldable display. From the top view of the display, the head of the screw may be seen.

An embodiment of this application provides still another embodiment of a foldable display, as shown in FIG. 15. The foldable display shown in FIG. 15 differs from the foldable display shown in FIG. 13 in that a first mechanical part 1 is disposed on a hinge 201, and a second mechanical part 2 is disposed on a middle frame 101 and a middle frame 102. For a top view of a display side corresponding to the foldable display shown in FIG. 15, refer to FIG. 14.

It should be understood that, in this embodiment of this application, only an example in which the first mechanical part 1 and the second mechanical part 2 are disposed on the hinge and the middle frame is used to describe connections between different components of the foldable display. The first mechanical part 1 and the second mechanical part 2 may alternatively be disposed on other components of the foldable display. This is not limited in this application. Certainly, a connection structure between the first mechanical part 1 and the second mechanical part 2 may be further used to connect components in a non-foldable electronic device. This is not limited in this application.

This application further provides a foldable electronic device, including the foldable display in the foregoing embodiment.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable display, comprising a display, a middle frame, a hinge, and a fastener (3), wherein
the display is disposed above the middle frame and the hinge, the middle frame and the hinge are fastened by using the fastener (3), and the middle frame comprises a first mechanical part (1) and the hinge comprises a second mechanical part (2), or the middle frame comprises the second mechanical part (2) and the hinge comprises the first mechanical part (1);
the first mechanical part (1) is provided with a protruding portion (11), a bearing portion (13), and a threaded hole (15), the protruding portion (11) protrudes from an end face of the bearing portion (13), and the threaded hole (15) is at least partially provided on the protruding portion (11);
the second mechanical part (2) is provided with a first through hole (21), the second mechanical part (2) is sleeved on a periphery of the protruding portion (11) through the first through hole (21), the second mechanical part (2) comprises a first end face (23) and a second end face (25) that are opposite to each other, and the first end face (23) abuts against the bearing portion (13); and
the fastener (3) comprises a base portion (31) and a threaded portion (33), the threaded portion (33) protrudes from a third end face (35) of the base portion (31), the fastener (3) and the first mechanical part (1) are connected through engagement between the threaded portion (33) and the threaded hole (15), and the third end face (35) of the base portion (31) abuts against the second end face (25) of the second mechanical part (2).

2. The foldable display according to claim 1, wherein a difference between a diameter d2 of the first through hole (21) and an outer diameter d3 of the protruding portion (11) is greater than a first threshold.

3. The foldable display according to claim 1 or 2, wherein an end that is of the second mechanical part (2) and that is close to the base portion (31) comprises a countersunk hole (27), the second end face (25) is an end face between the first through hole (21) and the countersunk hole (27), and the second mechanical part (2) is sleeved on a periphery of the base portion (31) through the countersunk hole (27).

4. The foldable display according to any one of claims 1 to 3, wherein an opening that is of the threaded hole (15) and that is close to the base portion (31) is provided with a chamfer.

5. The foldable display according to any one of claims 1 to 4, wherein a thread length of the threaded hole (15) is more than three times a pitch of the threaded hole (15).

6. The foldable display according to any one of claims 1 to 5, wherein
the protruding portion (11) is a nut, and the bearing portion (13) further comprises a second through hole (131);
the nut comprises a head (111) and a shank (113), the shank (113) protrudes from an end face of the head (111), and the threaded hole (15) is provided in the nut; and
the nut is secured in the second through hole (131), the shank (113) extends out of the end face of the bearing portion (13), and the shank (113) is accommodated in the first through hole (21).

7. The foldable display according to any one of claims 1 to 6, wherein the threaded portion (33) of the fastener (3) faces away from or toward the display.

8. The foldable display according to any one of claims 1 to 7, wherein an end part of the threaded portion (33) of the fastener (3) does not protrude from an end face that is of the first mechanical part (1) and that is away from the second mechanical part (2).

9. A connection component, used in a foldable electronic device, wherein the connection component comprises a first mechanical part (1), a second mechanical part (2), and a fastener (3);
the first mechanical part (1) is provided with a protruding portion (11), a bearing portion (13), and a threaded hole (15), the protruding portion (11) protrudes from an end face of the bearing portion (13), and the threaded hole (15) is at least partially provided on the protruding portion (11);
the second mechanical part (2) is provided with a first through hole (21), the second mechanical part (2) is sleeved on a periphery of the protruding portion (11) through the first through hole (21), the second mechanical part (2) comprises a first end face (23) and a second end face (25) that are opposite to each other, and the first end face (23) abuts against the bearing portion (13); and
the fastener (3) comprises a base portion (31) and a threaded portion (33), the threaded portion (33) protrudes from a third end face (35) of the base portion (31), the fastener (3) and the first mechanical part (1) are connected through engagement between the threaded portion (33) and the threaded hole (15), and the third end face (35) of the base portion (31) abuts against the second end face (25) of the second mechanical part (2).

10. The connection component according to claim 9, wherein a difference between a diameter d2 of the first through hole (21) and an outer diameter d3 of the protruding portion (11) is greater than a first threshold.

11. The connection component according to claim 9 or 10, wherein an end that is of the second mechanical part (2) and that is close to the base portion (31) comprises a countersunk hole (27), the second end face (25) is an end face between the first through hole (21) and the countersunk hole (27), and the second mechanical part (2) is sleeved on a periphery of the base portion (31) through the countersunk hole (27).

12. The connection component according to any one of claims 9 to 11, wherein an opening that is of the threaded hole (15) and that is close to the base portion (31) is provided with a chamfer.

13. The connection component according to any one of claims 9 to 12, wherein a thread length of the threaded hole (15) is more than three times a pitch of the threaded hole (15).

14. The connection component according to any one of claims 9 to 13, wherein
the protruding portion (11) is a nut, and the bearing portion (13) further comprises a second through hole (131);
the nut comprises a head (111) and a shank (113), the shank (113) protrudes from an end face of the head (111), and the threaded hole (15) is provided in the nut; and
the nut is secured in the second through hole (131), the shank (113) extends out of the end face of the bearing portion (13), and the shank (113) is accommodated in the first through hole (21).

15. The connection component according to any one of claims 9 to 14, wherein an end part of the threaded portion (33) of the fastener (3) does not protrude from an end face that is of the first mechanical part (1) and that is away from the second mechanical part (2).

16. A foldable electronic device, comprising the foldable display according to any one of claims 1 to 8.
